(19) Europäisches Patentamt
European Patent Office
Office européen des brevets

(11) Veröffentlichungsnummer: **0 355 387 B1**

(12) # EUROPÄISCHE PATENTSCHRIFT

(45) Veröffentlichungstag der Patentschrift: **09.03.94**

(51) Int. Cl.$^5$: **G03F 7/027**

(21) Anmeldenummer: **89113035.3**

(22) Anmeldetag: **15.07.89**

(54) **Photopolymerisierbares Gemisch und daraus hergestelltes Aufzeichnungsmaterial.**

(30) Priorität: **22.07.88 DE 3824903**

(43) Veröffentlichungstag der Anmeldung:
**28.02.90 Patentblatt 90/09**

(45) Bekanntmachung des Hinweises auf die Patenterteilung:
**09.03.94 Patentblatt 94/10**

(84) Benannte Vertragsstaaten:
**DE FR GB**

(56) Entgegenhaltungen:
**EP-A- 0 222 320**
**EP-A- 0 287 817**
**DE-A- 3 106 366**
**US-A- 4 174 307**

(73) Patentinhaber: **HOECHST AKTIENGESELL-SCHAFT**

**D-65926 Frankfurt(DE)**

(72) Erfinder: **Zertani, Rudolf, Dr.**
**Michael-Müller-Ring 37**
**D-6500 Mainz-Bretzenheim(DE)**
Erfinder: **Mohr, Dieter, Dr.**
**Eaubonner Strasse 8**
**D-6501 Budenheim(DE)**
Erfinder: **Rode, Klaus, Dr. Hoechst do Brasil,**
**Fabrica Suzano**
**Av. Jorge BeiMaluf 2073/2173**
**CEP 08600 Suzano-SP(BR)**

**EP 0 355 387 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein photopolymerisierbares Gemisch, das ein polymeres Bindemittel, eine polymerisierbare Verbindung mit mindestens zwei Acryl- oder Alkacrylsäureestergruppen im Molekül sowie eine Photoinitiatorkombination enthält.

Photopolymerisierbare Gemische, die als polymerisierbare Verbindungen Acryl- und/oder Methacrylsäureester enthalten, sind bekannt. Für die Herstellung von Photoresistmaterialien, insbesondere von Trockenphotoresistschichten, werden dabei Gemische bevorzugt, die Acryl- oder Methacrylsäureester mit Urethangruppen im Molekül enthalten und die sich mit wäßrig-alkalischen Lösungen entwickeln lassen. Derartige Gemische sind z. B. in den US-A 3 782 961, 3 850 770, 3 960 572, 4 019 972 und 4 250 248 beschrieben.

Andererseits sind auch photopolymerisierbare Gemische bekannt, die zur Erhöhung der Lichtempfindlichkeit bestimmte Kombinationen von Photoinitiatoren und Aktivatoren, z. B. von Carbonylgruppen enthaltenden Initiatoren und tertiären Aminen, enthalten. Derartige synergistisch wirkende Gemische sind z. B. in den US-A 3 759 807, 4 054 682 und 4 071 424 beschrieben. Ein Nachteil dieser Gemische die niedermolekulare Amine enthalten, besteht darin, daß sie eine geringere Lagerstabilität aufweisen, da die Amine, insbesondere aus dünnen Schichten, leicht ausschwitzen können.

In der JP-A 50/129 214, angemeldet am 2.4.1974 unter der Nummer 49/36614, wird ein photopolymerisierbares Gemisch beschrieben, das als polymerisierbare Verbindung einen Tetra(meth)acrylsäureester eines N,N,N',N'-Tetrahydroxyalkyl-alkylendiamins enthält. Die tetrafunktionelle Verbindung dient als Vernetzungsmittel.

Es ist weiterhin bekannt, daß man die radikalische Polymerisation von ethylenisch ungesättigten Verbindungen durch Bestrahlung mit sichtbarem Licht in Gegenwart von photoreduzierbaren Farbstoffen und Reduktionsmitteln, z. B. Aminen, anstoßen kann (US-A 3 097 096). Diese Initiatorkombinationen werden jedoch im wesentlichen nur in wäßriger Lösung oder in Kombination mit wasserlöslichen Bindemitteln eingesetzt.

Initiatorkombinationen aus photoreduzierbaren Farbstoffen und anderen Reduktionsmitteln sind in den US-A 3 597 343 und 3 488 269 beschrieben. Photopolymerisierbare Gemische, die als Initiatoren ausschließlich photoreduzierbare Farbstoffe enthalten, sind wegen ihrer zu geringen Lichtempfindlichkeit bisher praktisch nicht eingesetzt worden.

In der JP-A 54/151 024 ist ein photopolymerisierbares Gemisch beschrieben, das eine Initiatorkombination aus einem Merocyaninfarbstoff und einem trihalogenmethylsubstituierten s-Triazin enthält und gegenüber sichtbarem Licht, z. B. einem Argonlaser, empfindlich ist. Die Empfindlichkeit dieser Gemische gegenüber sichtbarem Laserlicht ist jedoch für eine wirtschaftliche Nutzung nicht ausreichend.

In der älteren EP-A 287 817 werden photopolymerisierbare Gemische beschrieben, die (Meth)-acrylsäureester mit Urethangruppen, tertiären Aminogruppen und ggf. Harnstoffgruppen im Molekül, polymere Bindemittel und, als Photoinitiatoren, eine Kombination aus einem photoreduzierbaren Farbstoff, einer strahlungsempfindlichen Trihalogenmethylverbindung und einer Acridin-, Phenazin- oder Chinoxalinverbindung enthalten.

Aufgabe der Erfindung war es, photopolymerisierbare Gemische mit guter Lagerstabilität vorzuschlagen, die sich zur Herstellung von Druckplatten hoher Auflagenleistung und Photoresists mit hoher Resistenz gegen Verarbeitungslösungen im gehärteten Zustand eignen, die sich durch eine hohe Lichtempfindlichkeit im nahen Ultraviolett- und im sichtbaren Spektralbereich auszeichnen und daher insbesondere zur Laserstrahlaufzeichnung im sichtbaren Bereich geeignet sind.

Erfindungsgemäß wird ein photopolymerisierbares Gemisch vorgeschlagen, das als wesentliche Bestandteile

a) ein polymeres Bindemittel,
b) einen Acryl- oder Alkacrylsäureester eines mehrwertigen Alkohols,
c) einen photoreduzierbaren Farbstoff,
d) eine durch Strahlung spaltbare Trihalogenmethylverbindung und
e) eine als Photoinitiator wirksame Acridin-, Phenazin- oder Chinoxalinverbindung enthält.

Das erfindungsgemäße Gemisch ist dadurch gekennzeichnet, daß der Acryl- und Alkacrylsäureester der Formel I

$$Q\left[(-X^1-CH_2O)_a-CONH(-X^2-NHCOO)_b-X^3-OOC-\overset{\displaystyle R}{\overset{|}{C}}=CH_2\right]_n \quad (I)$$

entspricht, worin

Q

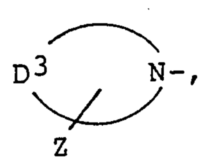

R ein Wasserstoffatom, eine Methyl- oder Ethylgruppe,

$X^1$ $C_mH_{2m}$ oder

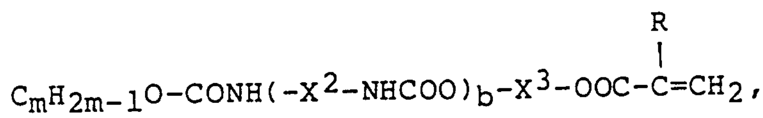

$X^2$ eine gesättigte Kohlenwasserstoffgruppe mit 2 bis 12 Kohlenstoffatomen,

$X^3$ eine gesättigte Kohlenwasserstoffgruppe, die durch 1 bis 5 Ethersauerstoffatome unterbrochen sein kann,

$D^3$ eine gesättigte Kohlenwasserstoffgruppe mit 4 bis 8 Kohlenstoffatomen, die mit dem Stickstoffatom einen 5- oder 6-gliedrigen Ring bildet,

Z ein Wasserstoffatom oder einen Rest der Formel

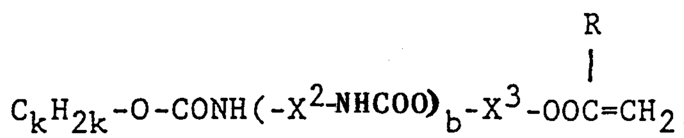

a 0 oder eine ganze Zahl von 1 bis 4,

b 0 oder 1,

m und k ganze Zahlen von 1 bis 12 und

n je nach Wertigkeit von Q 1, 2 oder 3

bedeutet, wobei alle Reste gleicher Definition untereinander gleich oder verschieden sein können und wobei in mindestens einem Substituenten an der Gruppe Q a = O ist.

Wenn in der Verbindung der allgemeinen Formel I mehr als ein Rest des in eckigen Klammern angegebenen Typs an die zentrale Gruppe Q gebunden ist, so können diese Reste untereinander verschieden sein.

Verbindungen der Formel I mit mindestens zwei polymerisierbaren Acryl- oder Alkacrylsäureestergruppen werden bevorzugt.

Von den Verbindungen der Formel I werden solche bevorzugt, die außer einer Harnstoffgruppe mindestens eine Urethangruppe enthalten. Als Harnstoffgruppen sollen Gruppen der Formel

$>N - CO - N<$

angesehen werden, bei denen die Valenzen am Stickstoff mit ggf. substituierten Kohlenwasserstoffresten abgesättigt sind. Es kann aber auch eine Valenz an einem Stickstoffatom an eine weitere Carbonylamidgruppe (CONH) gebunden sein, so daß eine Biuretstruktur entsteht. Auch derartige Verbindungen sind erfindungsgemäß geeignet.

R ist bevorzugt ein Wasserstoffatom oder eine Methylgruppe, insbesondere eine Methylgruppe.

$X^2$ ist bevorzugt ein geradkettiger oder verzweigter aliphatischer oder cycloaliphatischer Rest mit vorzugsweise 4 bis 10 Kohlenstoffatomen.

$X^3$ hat vorzugsweise 2 bis 15 Kohlenstoffatome. Wenn es sich um reine Kohlenstoffketten handelt, werden im allgemeinen solche mit 2 bis 12, vorzugsweise 2 bis 6 Kohlenstoffatomen eingesetzt. $X^3$ kann auch eine cycloaliphatische Gruppe mit 5 bis 10 Kohlenstoffatomen, insbesondere eine Cyclohexylengruppe

sein.

Das Symbol a ist vorzugsweise 0 oder 1; m ist vorzugsweise eine Zahl von 2 bis 10.

Die polymerisierbaren Verbindungen der Formel I, die zwei Urethangruppen in jedem Rest (b = 1) enthalten, werden dargestellt, indem Acryl- oder Alkylacrylsäureester, die freie Hydroxygruppen enthalten, in bekannter Weise mit der gleichen Molmenge an Diisocyanaten umgesetzt werden und die überschüssige Isocyanatgruppe mit Hydroxyalkylaminen umgesetzt wird. Wenn a = 0 ist, entsteht eine Harnstoffgruppierung.

Beispiele für die als Ausgangsstoffe verwendeten Hydroxyalkylamine sind 2-Hydroxyethyl-piperidin, 2-Hydroxymethyl-piperidin, 3-Hydroxymethyl-piperidin und 4-Hydroxyethyl-piperidin.

Beispiele für die als Ausgangsstoffe verwendeten Diisocyanate sind Ethylendiisocyanat, Propylendiisocyanat, Butylen-1,3-diisocyanat, Hexamethylendiisocyanat, 2,2,4-Trimethyl-hexamethylendiisocyanat, 2,4-Dimethyl-6-ethyl-octamethylendiisocyanat, 1,4-Cyclohexylendiisocyanat, 1,3-Cyclopentylendiisocyanat, 1,4-Diisocyanatomethyl-cyclohexan und 1,1,3-Trimethyl-3-isocyanatomethyl-5-isocyanatocyclohexan.

Als Hydroxygruppen enthaltende Ester werden insbesondere Hydroxyethylmethacrylat und Hydroxypropylmethacrylat (n oder iso) sowie die entsprechenden Acrylate verwendet. Mit Vorteil können jedoch auch folgende Verbindungen verwendet werden:

2-Hydroxy-butylmethacrylat, 4-Hydroxy-butylmethacrylat, 2-Hydroxy-cyclohexylmethacrylat und andere Hydroxyalkylmethacrylate mit bis zu 12, vorzugsweise bis zu 6 Kohlenstoffatomen im Alkylrest, Diethylenglykolmonomethacrylat, Triethylenglykolmonomethacrylat und andere Polyethylenglykolmonomethacrylate mit bis zu 5 Oxyethyleneinheiten sowie die entsprechenden Acrylate.

Die polymerisierbaren Verbindungen der Formel I mit b = 0 werden dargestellt, indem die oben beschriebenen Hydroxyalkylamine mit Isocyanatgruppen enthaltenden Acryl- oder Alkylacrylsäureestern umgesetzt werden.

Als Isocyanatgruppen enthaltender Ester wird insbesondere Isocyanatoethyl(meth)acrylat eingesetzt. Mit Vorteil können jedoch auch folgende Verbindungen verwendet werden: 3-Isocyanatopropylmethacrylat, 4-Isocyanatobutylmethacrylat, Isocyanatoisohexylmethacrylat und andere Isocyanatoalkyl(meth)acrylate mit bis zu 12, vorzugsweise bis zu 6 Kohlenstoffatomen im Alkylrest.

Die Umsetzung der Isocyanate mit den OH-Gruppen enthaltenden Aminen und Alkylacrylaten wird zweckmäßig in einem inerten Lösemittel wie Toluol, Pyridin oder Methylethylketon durchgeführt. Zur thermischen Stabilisierung der stark zur Polymerisation neigenden Produkte werden Chinone oder Phenole, vorzugsweise 2,6-Di-tert. butyl-p-kresol, in Konzentrationen von 0,01 - 2 Gew.-% zugesetzt.

Neben anderen Bestandteilen sind die vorstehend beschriebenen polymerisierbaren Verbindungen mit mindestens einer Harnstoffgruppierung neben Urethangruppen im Molekül für die hohe Lichtempfindlichkeit der photopolymerisierbaren Gemische verantwortlich. Monomere, die ausschließlich Urethangruppen im Molekül aufweisen bzw. nicht der Formel I entsprechen, haben eine deutlich schlechtere Lagerstabilität. Eine mögliche Ursache dafür kann die Ausbildung von Wasserstoffbrücken zwischen Harnstoffgruppen und polymerem Bindemittel sein, die eine geringere Empfindlichkeit gegen Sauerstoff zur Folge haben kann.

Außer den beschriebenen photooxydierbaren polymerisierbaren Verbindungen können auch herkömmliche polymerisierbare Verbindungen, die zwei oder mehr polymerisierbare Acryl- oder Methacrylsäureestergruppen enthalten, zugesetzt werden. Beispiele sind Acryl- und Methacrylsäureester von zwei-oder mehrwertigen Alkoholen, wie Ethylenglykoldiacrylat, Polyethylenglykoldimethacrylat, Acrylate und Methacrylate von Trimethylolethan, Trimethylolpropan, Pentaerythrit und Dipentaerythrit und von mehrwertigen alicyclischen Alkoholen. Mit Vorteil werden auch Umsetzungsprodukte von Diisocyanaten mit ungesättigten Partialestern mehrwertiger Alkohole eingesetzt. Derartige Monomere sind in den DE-A 20 64 079, 23 61 041 und 28 22 190 beschrieben.

Der Mengenanteil des Gemischs an Monomeren beträgt im allgemeinen etwa 10 bis 80, vorzugsweise 20 bis 60 Gew.-%.

Das erfindungsgemäße Gemisch enthält als Photoinitiatorbestandteil einen photoreduzierbaren Farbstoff. Geeignete Farbstoffe sind insbesondere Xanthen-, Benzoxanthen-, Benzothioxanthen-, Thiazin-, Pyronin, Porphyrin- oder Acridinfarbstoffe.

Bevorzugte Vertreter der Xanthenfarbstoffe sind Verbindungen der allgemeinen Formel II

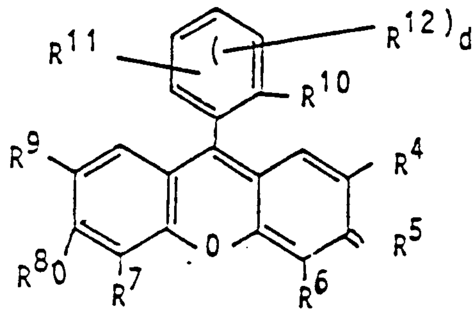

(II)

worin

| | |
|---|---|
| $R^4$ und $R^9$ | gleich oder verschieden sind und Wasserstoff- oder Halogenatome, Nitro- oder Hydroxygruppen oder Gruppen der Formel -HgOH bedeuten, |
| $R^6$ und $R^7$ | gleich oder verschieden sind und Wasserstoff-oder Halogenatome oder Hydroxygruppen, |
| $R^5$ | O oder $^{(+)}$NHAlkyl $X^{(-)}$, |
| $R^8$ | ein Wasserstoffatom, Alkalimetall-, Ammonium- oder Trialkylammoniumkation, eine Alkyl- oder Acylgruppe, |
| $R^{10}$ | ein Wasserstoffatom oder eine Gruppe $COOR^{13}$, |
| $R^{11}$ | ein Wasserstoff- oder Halogenatom oder eine Aminogruppe, |
| $R^{12}$ | ein Wasserstoff- oder Halogenatom, |
| $R^{13}$ | ein Wasserstoffatom, ein Alkalimetall- oder Ammoniumkation, eine Alkylgruppe oder ein polymerer Rest, |
| X | ein Anion und |
| d | Null oder eine ganze Zahl von 1 bis 3 bedeutet. |

Wenn die Reste $R^5$, $R^8$ und $R^{13}$ Alkylreste sind oder solche enthalten, haben diese im allgemeinen 1 bis 25, insbesondere 1 bis 18 Kohlenstoffatome.

In der Praxis enthält das erfindungsgemäße photopolymerisierbare Aufzeichnungsmaterial häufig eine sauerstoffhemmende Deckschicht. Befindet sich in dieser Deckschicht ein Xanthenfarbstoff, führt dies zu einer Beschattung der unterliegenden lichtempfindlichen Schicht und damit zu einer Empfindlichkeitseinbuße. Deshalb werden in der photopolymerisierbaren Schicht mit Vorteil Farbstoffe der Formel II verwendet, deren Alkylreste $R^5$, $R^8$ und besonders $R^{13}$ relativ langkettig sind und dadurch die Migration in die Deckschicht verhindern. Mit besonderem Vorteil werden Farbstoffe der Formel II verwendet, deren Rest $R^{13}$ ein Alkylrest mit mehr als 8 Kohlenstoffatomen ist.

Geeignete Thiazinfarbstoffe sind Verbindungen der Formel III und geeignete Pyroninfarbstoffe Verbindungen der Formel IV

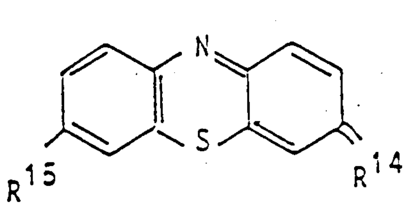

(III)

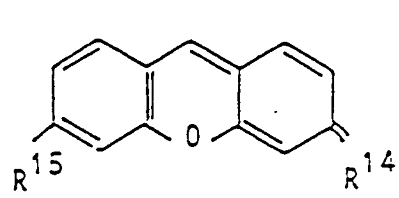

(IV)

worin

| | |
|---|---|
| $R^{14}$ | eine der Gruppen $=NH_2^{(+)} X^{(-)}$, $=NHAlkyl^{(+)} X^{(-)}$ und $=N(Alkyl)_2^{(+)} X^{(-)}$, |
| $R^{15}$ | eine Amino-, Alkylamino- oder Dialkylaminogruppe und |
| X | ein Anion ist. |

In den Formeln III und IV haben Alkylgruppen die gleiche Bedeutung wie in der Formel II.

Geeignete Benzoxanthen- und Benzothioxanthenfarbstoffe sind in der DE-A 20 25 291 und der älteren EP-A 321 828 beschrieben.

Als Porphyrinfarbstoff ist z. B. Hämatoporphyrin und als Acridinfarbstoff z. B. AcriflaviniumchloridHydrochlorid geeignet. Beispiele für Verbindungen der Formel II sind Eosin B (C.I. Nr. 45 400), Eosin J (C.I. Nr.

45 380), Eosin alkohollöslich (C.I. 45 386), Cyanosin (C.I. Nr. 45 410), Bengalrosa, Erythrosin (C.I. Nr. 45 430), 2,3,7-Trihydroxy-9-phenyl-xanthen-6-on und Rhodamin 6 G (C.I. Nr. 45 160).

Beispiele für Verbindungen der Formel III sind Thionin (C.I. Nr. 52 000), Azur A (C.I. Nr. 52 005) und Azur C (C.I. Nr. 52 002).

Beispiele für Farbstoffe der Formel IV sind Pyronin B (C.I. Nr. 45 010) und Pyronin GY (C.I. Nr. 45 005). Die Menge der Komponente (c) des Gemischs liegt im allgemeinen zwischen 0,01 und 10, vorzugsweise zwischen 0,05 und 4 Gew.-%, bezogen auf die nichtflüchtigen Anteile des Gemisches.

Zur Steigerung der Lichtempfindlichkeit enthalten die erfindungsgemäßen Gemische Verbindungen mit photolytisch spaltbaren Trihalogenmethylgruppen (d) die als radikalbildende Photoinitiatoren für photopolymerisierbare Gemische an sich bekannt sind. Als derartige Coinitiatoren haben sich besonders Verbindungen mit Chlor und Brom, insbesondere Chlor, als Halogene bewährt. Die Trihalogenmethylgruppen können direkt oder über eine durchkonjugierte Kette an einen aromatischen carbo- oder heterocyclischen Ring gebunden sein. Bevorzugt werden Verbindungen mit einem Triazinring im Grundkörper, der bevorzugt 2 Trihalogenmethylgruppen trägt, insbesondere solche, wie sie in der EP-A 137 452, der DE-A 27 18 259 und der DE-A 22 43 621 beschrieben sind. Diese Verbindungen haben starke Lichtabsorptionen im nahen UV-Bereich, etwa um 350-400 nm. Es sind auch Coinitiatoren geeignet, die selbst im Spektralbereich des Kopierlichts nicht oder nur wenig absorbieren, wie Trihalogenmethyltriazine, die Substituenten mit kürzeren mesomeriefähigen Elektronensystemen oder aliphatische Substituenten enthalten. Auch Verbindungen mit anderem Grundgerüst, die im kürzerwelligen UV-Bereich absorbieren, z. B. Phenyl-trihalogenmethyl-sulfone oder Phenyl-trihalogenmethyl-ketone, z. B. das Phenyltribrommethylsulfon, sind geeignet.

Die Komponenten (d) werden im allgemeinen in einer Menge von 0,01 bis 10, vorzugsweise von 0,05 bis 6 Gew.-%, bezogen auf die nichtflüchtigen Bestandteile des Gemischs, eingesetzt.

Die erfindungsgemäßen Gemische enthalten als weiteren Initiatorbestandteil eine Acridin-, Phenazin- oder Chinoxalinverbindung (e). Diese Verbindungen sind als Photoinitiatoren bekannt und in den DE-C 20 27 467 und 20 39 861 beschrieben. Durch diese Verbindungen wird die Empfindlichkeit des Gemischs vor allem im nahen Ultraviolettbereich gesteigert. Geeignete Vertreter dieser Verbindungsklasse sind in der genannten DE-C beschrieben. Beispiele sind in 9-Stellung substituierte Acridine, wie 9-Phenyl-, 9-p-Methoxyphenyl- oder 9-Acetylamino-acridin, oder Acridinderivate mit ankondensierten aromatischen Kernen, z. B. Benz(a)acridin. Als Phenazinderivat ist z. B. das 9,10-Dimethyl-benz(a)phenazin geeignet.

Als Chinoxalinderivate kommen insbesondere die 2,3-Diphenylderivate in Betracht, die vorzugsweise in den beiden Phenylresten durch Methoxygruppen weiter substituiert sind. Im allgemeinen werden als Komponenten (e) die Acridinderivate bevorzugt.

Die Menge der Komponente (e) im Gemisch liegt ebenfalls im Bereich von 0,01 bis 10 Gew.-%, vorzugsweise zwischen 0,05 und 5 Gew.-%.

Wenn eine weitere Empfindlichkeitssteigerung des Gemischs im sichtbaren Spektralbereich erwünscht ist, kann diese durch Zusatz einer Verbindung (f) vom Dibenzalaceton- oder Cumarintyp erreicht werden. Dieser Zusatz bewirkt eine höhere Auflösung der Kopie und eine durchgehende Sensibilisierung des Gemischs für den sichtbaren Spektralbereich bis zu Wellenlängen von etwa 600 nm. Geeignete Vertreter dieser Verbindungen sind 4,4′-disubstituierte Dibenzalacetone, z. B. 4-Diethylamino-4′-methoxy-dibenzalaceton, oder Cumarinderivate wie 3-Acetyl-7-diethylamino-, 3-Benzimidazolyl-7-diethylamino- oder Carbonyl-bis-(7-diethylaminocumarin). Die Menge der Verbindung (f) liegt ebenfalls im Bereich von 0,01 bis 10, vorzugsweise von 0,05 bis 4 Gew.-%, bezogen auf die nichtflüchtigen Bestandteile des Gemischs.

Die Gesamtmenge an Polymerisationsinitiatoren (c), (d) und (e) oder ggf. die Gesamtmenge einschließlich der Komponente (f) liegt im allgemeinen bei 0,05 bis 20, vorzugsweise bei 0,1 bis 10 Gew.-%. Das Molverhältnis der Bestandteile (c), (d), (e) und (f) untereinander liegt bevorzugt in den folgenden Bereichen (c) : (d) : (e) : (f) = 1 : (4-10) : (1-5) : (0-4).

Als Bindemittel können eine Vielzahl löslicher organischer Polymerisate Einsatz finden. Als Beispiele seien genannt: Polyamide, Polyvinylester, Polyvinylacetale, Polyvinylether, Epoxidharze, Polyacrylsäureester, Polymethacrylsäureester, Polyester, Alkydharze, Polyacrylamid, Polyvinylalkohol, Polyethylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Mit besonderem Vorteil werden Bindemittel verwendet, die wasserunlöslich, aber in wäßrig-alkalischen Lösungen löslich oder mindestens quellbar sind, da sich Schichten mit solchen Bindemitteln mit den bevorzugten wäßrigalkalischen Entwicklern entwickeln lassen. Derartige Bindemittel können z. B. die folgenden Gruppen enthalten: -COOH, $-PO_3H_2$, $-SO_3H$; $-SO_2NH-$, $-SO_2-NH-SO_2-$ und $-SO_2-NH-CO-$.

Als Beispiele hierfür seien genannt: Maleinatharze, Polymerisate aus N-(p-Tolyl-sulfonyl)-carbaminsäure-ß-(methacryloyloxy)-ethylester und Mischpolymerisate dieser und ähnlicher Monomerer mit anderen Monomeren sowie Vinylacetat/Crotonsäure- und Styrol/Maleinsäureanhydrid-Mischpolymerisate. Alkylmethacrylat/Methacrylsäure-Mischpolymerisate und Mischpolymerisate aus Methacrylsäure, höheren Alkylmethacrylaten und Methylmethacrylat und/oder Styrol, Acrylnitril u. a., wie sie in den DE-A 20 64 080 und 23 63 806 beschrieben sind, werden bevorzugt.

Die Menge des Bindemittels beträgt im allgemeinen 20 bis 90, vorzugsweise 30 bis 80 Gew.-% der Bestandteile der Schicht.

Die photopolymerisierbaren Gemische können je nach geplanter Anwendung und je nach den gewünschten Eigenschaften verschiedenartige Stoffe als Zusätze enthalten. Beispiele sind: Inhibitoren zur Verhinderung der thermischen Polymerisation der Monomeren, Wasserstoffdonatoren, Farbstoffe, gefärbte und ungefärbte Pigmente, Farbbildner, Indikatoren, Weichmacher und Kettenüberträger.

Diese Bestandteile sind zweckmäßig so auszuwählen, daß sie in dem für den Initiierungsvorgang wichtigen aktinischen Strahlungsbereich möglichst wenig absorbieren.

Als aktinische Strahlung soll im Rahmen dieser Beschreibung jede Strahlung verstanden werden, deren Energie mindestens der des sichtbaren Lichts entspricht. Geeignet ist vor allem sichtbares Licht und langwellige UV-Strahlung, aber auch kurzwellige UV-Strahlung, Laserstrahlung, Elektronen- und Röntgenstrahlung.

Das photopolymerisierbare Gemisch kann für die verschiedensten Anwendungen Einsatz finden, beispielsweise zur Herstellung von Lacken, die durch Licht gehärtet werden, als Zahnfüll- oder -ersatzmaterial und insbesondere als lichtempfindliches Aufzeichnungsmaterial auf dem Reproduktionsgebiet.

Die detaillierte Beschreibung der Erfindung beschränkt sich auf dieses Anwendungsgebiet, jedoch ist die Erfindung nicht hierauf beschränkt. Als Anwendungsmöglichkeiten auf diesem Gebiet seien genannt: Aufzeichnungsschichten für die photomechanische Herstellung von Druckformen für den Hochdruck, den Flachdruck, den Tiefdruck, den Siebdruck, von Reliefkopien, z. B. Herstellung von Texten in Blindenschrift, von Einzelkopien, Gerbbildern, Pigmentbildern usw.. Weiter sind die Gemische zur photomechanischen Herstellung von Ätzreservagen, z. B. für die Fertigung von Namensschildern, von kopierten Schaltungen und für das Formteilätzen, anwendbar. Besondere Bedeutung haben die erfindungsgemäßen Gemische als Aufzeichnungsschichten für die Herstellung von Flachdruckplatten und für die Photoresisttechnik.

Die gewerbliche Verwertung des Gemischs für die genannten Anwendungszwecke kann in der Form einer flüssigen Lösung oder Dispersion, z. B. als Photoresistlösung, erfolgen, die vom Verbraucher selbst auf einen individuellen Träger, z. B. zum Formteilätzen, für die Herstellung kopierter Schaltungen, von Siebdruckschablonen und dgl., aufgebracht wird. Das Gemisch kann auch als feste lichtempfindliche Schicht auf einem geeigneten Träger in Form eines lagerfähig vorbeschichteten lichtempfindlichen Kopiermaterials, z. B. für die Herstellung von Druckplatten, vorliegen, Ebenso ist es für die Herstellung von Trockenresist geeignet.

Es ist im allgemeinen günstig, die Gemische während der Lichtpolymerisation dem Einfluß des Luftsauerstoffs weitgehend zu entziehen. Im Fall der Anwendung des Gemischs in Form dünner Kopierschichten ist es empfehlenswert, einen geeigneten, für Sauerstoff wenig durchlässigen Deckfilm aufzubringen. Dieser kann selbsttragend sein und vor der Entwicklung der Kopierschicht abgezogen werden. Für diesen Zweck sind z. B. Polyesterfilme geeignet. Der Deckfilm kann auch aus einem Material bestehen, das sich in der Entwicklerflüssigkeit löst oder mindestens an den nicht gehärteten Stellen bei der Entwicklung entfernen läßt. Hierfür geeignete Materialien sind z. B. Wachse, Polyvinylalkohol, Polyphosphate, Zucker usw.. Solche Deckschichten haben im allgemeinen eine Dicke von 0,1 bis 10, vorzugsweise 1 bis 5 µm.

Als Schichtträger für mit dem erfindungsgemäßen Gemisch hergestellte Kopiermaterialien sind beispielsweise Aluminium, Stahl, Zink, Kupfer und Kunststoff-Folien, z. B. aus Polyethylenterephthalat oder Celluloseacetat, sowie Siebdruckträger, wie Perlongaze, geeignet. Es ist in vielen Fällen günstig, die Trägeroberfläche einer Vorbehandlung (chemisch oder mechanisch) zu unterwerfen, deren Ziel es ist, die Haftung der Schicht richtig einzustellen, die lithographischen Eigenschaften der Trägeroberfläche zu verbessern oder das Reflexionsvermögen des Trägers im aktinischen Bereich der Kopierschicht herabzusetzen (Lichthofschutz).

Die Herstellung der lichtempfindlichen Materialien unter Verwendung des erfindungsgemäßen Gemischs erfolgt in bekannter Weise. So kann man dieses in einem Lösemittel aufnehmen und die Lösung bzw. Dispersion durch Gießen, Sprühen, Tauchen, Antrag mit Walzen usw. auf den vorgesehenen Träger aufbringen und anschließend trocknen. Dicke Schichten (z. B. von 250 µm und darüber) werden vorteilhaft durch Extrudieren oder Verpressen als selbsttragende Folie hergestellt, welche dann ggf. auf den Träger laminiert wird. Im Falle von Trockenresist werden Lösungen des Gemischs auf transparente Träger aufgebracht und getrocknet. Die lichtempfindlichen Schichten - Dicke etwa zwischen 10 und 100 µm - werden dann gleichfalls zunächst zusammen mit dem temporären Träger auf das gewünschte Substrat auflaminiert.

Durch die breite spektrale Empfindlichkeit des erfindungsgemäßen Gemisches können alle dem Fachmann geläufigen Lichtquellen verwendet werden, z. B. Röhrenlampen, Xenonimpulslampen, metallhalogeniddotierte Quecksilberdampf-Hochdrucklampen und Kohlenbogenlampen. Darüber hinaus ist bei den erfindungsgemäßen lichtempfindlichen Gemischen das Belichten in üblichen Projektions- und Vergrößerungsgeräten unter dem Licht der Meallfadenlampen und Kontaktbelichtung mit gewöhnlichen Glühbirnen möglich. Die Belichtung kann auch mit kohärentem Licht eines Lasers erfolgen. Geeignet für die Zwecke vorliegender Erfindung sind leistungsgerechte Laser, beispielsweise Argon-Ionen-, Krypton-Ionen-, Farbstoff-, Helium-Cadmium- und Helium-Neon-Laser, die insbesondere zwischen 250 und 650 nm emittieren. Der Laserstrahl kann mittels einer vorgegebenen programmierten Strich- und/oder Raster-Bewegung gesteuert werden.

Die weitere Verarbeitung der Materialien wird in bekannter Weise vorgenommen. Zur besseren Vernetzung der Schicht kann eine Nacherwärmung nach dem Belichten erfolgen. Zur Entwicklung werden sie mit einer geeigneten Entwicklerlösung, z. B. mit organischen Lösemitteln, aber bevorzugt mit einer schwach alkalischen wäßrigen Lösung, behandelt, wobei die unbelichteten Anteile der Schicht entfernt werden und die belichteten Bereiche der Kopierschicht auf dem Träger zurückbleiben.

Im folgenden werden Ausführungsbeispiele für die Erfindung angegeben. Dabei wird zunächst in Tabelle I eine Anzahl neuer polymerisierbarer Verbindungen aufgeführt.

Die Herstellung dieser Verbindungen erfolgt nach dem nachstehend angegebenen Verfahren. Die Verbindungen werden in den nachfolgenden Beispielen in erfindungsgemäßen Aufzeichnungsmaterialien als polymerisierbare Verbindungen eingesetzt. In den Beispielen stehen Gewichitsteile (Gt) und Volumteile (Vt) im Verhältnis von g zu ccm. Prozent- und Mengenverhältnisse sind, wenn nichts anderes angegeben ist, in Gewichtseinheiten zu verstehen.

1.) Allgemeine Vorschrift zur Darstellung der Verbindungen der allgemeinen Formel I mit b = 0 (Verbindungen 1 bis 3 in Tabelle I)

Die Hydroxyalkylgruppen enthaltende Aminoverbindung und das Isocyanatoalkyl(meth)acrylat werden im gewünschten Molverhältnis in der zehnfachen Menge des geeigneten Lösemittels (Toluol, Butanon, Pyridin) mit 0,01 Gew.-% Dibutylzinndilaurat und 0,01 Gew.-% 2,6-Di-tert.butyl-p-kresol solange unter Rückfluß erhitzt, bis die Isocyanatbande (2275 - 2250 $cm^{-1}$) IR-spektroskopisch nicht mehr nachzuweisen ist (in der Regel nach 5 bis 8 Stunden). Anschließend wird das Lösemittel im Vakuum bei 50° C abdestilliert. Die ungesättigte Verbindung verbleibt als viskoser Rückstand oder in kristalliner Form in praktisch quantitativer Ausbeute.

## Tabelle I

Verbindungen der allgemeinen Formel I
mit R = $CH_3$; $X^3$ = $CH_2CH_2$

| Verbindung Nr. | Q | $X^1$ | $X^2$ | Z | a | b | n |
|---|---|---|---|---|---|---|---|
| 1 | 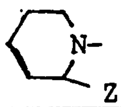 | - | - | $C_2H_4OZ^1$ | 0 | 0 | 1 |
| 2 | 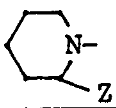 | - | - | $CH_2OZ^1$ | 0 | 0 | 1 |
| 3 | 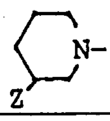 | - | - | $CH_2OZ^1$ | 0 | 0 | 1 |

Tabelle I
(Fortsetzung)

| Verbindung Nr. | Q | $X^1$ | $X^2$ | Z | a | b | n |
|---|---|---|---|---|---|---|---|
| 4 (V) | $CH_3-\underset{\vert}{N}-$ | $CH_2$ | - | - | 1 | 0 | 2 |
| | | " | - | - | 1 | 0 | |
| 5 (V) | $-\underset{\vert}{N}-$ | $CH_2$ | - | - | 1 | 0 | 3 |
| | | " | - | - | 1 | 0 | |
| | | " | - | - | 1 | 0 | |
| 6 (V) | $-\underset{\vert}{N}-$ | $CH_2$ | $(CH_2)_6$ | - | 1 | 1 | 3 |
| | | " | " | - | 1 | 1 | |
| | | " | " | - | 1 | 1 | |

V = Vergleichsversuch

$Z^1 = CONH-(CH_2)_2-OOC-\underset{CH_3}{\underset{\vert}{C}}=CH_2$

Beispiel 1

Als Schichtträger für Druckplatten wurde elektrochemisch aufgerauhtes und anodisiertes Aluminium mit einer Oxidschicht von 3 g/$m^2$ verwendet, das mit einer wäßrigen Lösung von Polyvinylphosphonsäure vorbehandelt worden war. Der Träger wurde mit einer Lösung folgender Zusammensetzung überzogen:

2,84 Gt einer 22,3 %igen Lösung eines Terpolymerisats aus Styrol, n-Hexylmethacrylat und Methacrylsäure (10:60:30) mit der Säurezahl 190 in Methylethylketon,
1,49 Gt Monomeres gemäß Tabelle II,
0,04 Gt Eosin alkohollöslich (C.I. 45 386),
0,03 Gt 2,4-Bis-trichlormethyl-6-(4-styrylphenyl)-s-triazin und
0,049 Gt 9-Phenylacridin in
22 Gt Propylenglykolmonomethylether.

Das Auftragen erfolgte durch Aufschleudern in der Weise, daß ein Trockengewicht von 2,0 bis 2,5 g/$m^2$ erhalten wurde. Anschließend wurde die Platte zwei Minuten bei 100 °C im Umlufttrockenschrank getrocknet. Die Platte wurde dann mit einer 7 %igen wäßrigen Lösung von Polyvinylalkohol (12 % Restacetylgruppen, K-Wert 4) beschichtet. Nach dem Trocknen wurde eine Deckschicht mit einem Gewicht von 2 bis 2,5g/$m^2$ erhalten. Die erhaltene Druckplatte wurde mittels einer 5 kW-Metallhalogenidlampe im Abstand von 110 cm unter einem 13-stufigen Belichtungskeil mit Dichteinkrementen von 0,15 belichtet, auf den, soweit angegeben, zusätzlich ein Silberfilm mit gleichmäßiger Schwärzung (Dichte 1,57) und gleichmäßiger Absorption über den wirksamen Spektralbereich als Graufilter montiert wurde. Um die Empfindlichkeit der Druckplatten im sichtbaren Licht zu testen, wurden auf den Belichtungskeil jeweils 3 mm starke Kantenfilter

der Firma Schott mit den in der Tabelle angegebenen Kantendurchlässigkeiten montiert. Nach der Belichtung wurde die Platte eine Minute auf 100° C erwärmt. Anschließend wurde sie mit einem Entwickler folgender Zusammensetzung entwickelt:
120 Gt Natriummetasilikat • 9 $H_2O$,
2,13 Gt Strontiumchlorid,
1,2 Gt nichtionogenes Netzmittel
(Kokosfettalkohol-Polyoxyethylenether mit ca. 8 Oxyethyleneinheiten) und
0,12 Gt Antischaummittel in
4000 Gt vollentsalztem Wasser.

Die Platte wurde mit fetter Druckfarbe eingefärbt. Es wurden die folgenden vollvernetzten Keilstufen erhalten:

Tabelle II

| Verbindung | Belichtung (Sekunden) | Graufilter | Kantenfilter (nm) | Keilstufen |
|---|---|---|---|---|
| 1 | 10 | ja | - | 10 |
| | 10 | nein | 455 | 9 |
| 2 | 10 | ja | - | 9 |
| | 10 | nein | 455 | 7 |
| 3 | 10 | ja | - | 8 |
| | 10 | nein | 455 | 6 |
| 4 (V) | 5 | ja | - | 8 |
| | 5 | nein | 455 | 6 |
| 5 (V) | 10 | ja | - | 11 |
| | 10 | nein | 455 | 9 |
| 6 (V) | 20 | ja | - | 7 |
| | 20 | nein | 455 | 5 |

Beispiel 2

Alle Druckplatten aus Beispiel 1 wurden auf ihre Lagerstabilität hin überprüft. Hierzu wurden die Druckplatten bei 80 °C mehrere Stunden in einem Umlufttrockenschrank gelagert. Nach den in Tabelle 3 angegebenen Zeiten wurden sie wie im Beispiel 1 verarbeitet. Es wurden folgende Anzahl vollvernetzter Keilstufen unter dem Kantenfilter 455 nm erhalten:

Tabelle 3

| Verbindung Nr. | Belichtung (Sekunden) | Kantenfilter (nm) | Lagerzeit (Stunden) | | | | |
|---|---|---|---|---|---|---|---|
| | | | 1/2 | 1 | 2 | 3 | 4 |
| | | | Keilstufen: | | | | |
| 1 | 10 | 455 | 8 | 8 | 8 | 8 | 7 |
| 2 | 10 | " | 7 | 7 | 7 | 6 | 6 |
| 4 (V) | 5 | " | 4 | 2* | - | - | - |
| 5 (V) | 10 | " | 8 | 7 | 6 | 2* | - |
| 6 (V) | 20 | " | 4 | 3 | 3 | 2 | - |

- keine Vernetzung (Durchhärtung)

* Platte nicht tonfrei

**Patentansprüche**

**1.** Photopolymerisierbares Gemisch, das als wesentliche Bestandteile
a) ein polymeres Bindemittel,
b) einen Acryl- oder Alkacrylsäureester eines mehrwertigen Alkohols,
c) einen photoreduzierbaren Farbstoff,
d) eine durch Strahlung spaltbare Trihalogenmethylverbindung und
e) eine als Photoinitiator wirksame Acridin-, Phenazin- oder Chinoxalinverbindung enthält,
dadurch gekennzeichnet, daß der Acryl- oder Alkacrylsäureester eine Verbindung der Formel I

$$Q\left[(-X^1-CH_2O)_a-CONH(-X^2-NHCOO)_b-X^3-OOC-\overset{R}{\overset{|}{C}}=CH_2\right]_n \qquad (I)$$

ist, worin
Q

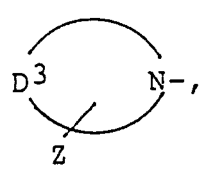

R ein Wasserstoffatom, eine Methyl- oder Ethylgruppe,
$X^1$ $C_mH_{2m}$ oder

$$C_mH_{2m-1}O-CONH(-X^2-NHCOO)_b-X^3-OOC-\overset{R}{\overset{|}{C}}=CH_2,$$

| | |
|---|---|
| $X^2$ | eine gesättigte Kohlenwasserstoffgruppe mit 2 bis 12 Kohlenstoffatomen, |
| $X^3$ | eine gesättigte Kohlenwasserstoffgruppe, die durch 1 bis 5 Ethersauerstoffatome unterbrochen sein kann, |
| $D^3$ | eine gesättigte Kohlenwasserstoffgruppe mit 4 bis 8 Kohlenstoffatomen, die mit dein Stickstoffatom einen 5- oder 6-gliedrigen Ring bildet, |
| Z | ein Wasserstoffatom oder einen Rest der Formel |

$$C_kH_{2k}\text{-O-CONH(-}X^2\text{-NHCOO)}_b\text{-}X^3\text{-OO}\overset{R}{\overset{|}{C}}\text{=}CH_2,$$

| | |
|---|---|
| a | 0 oder eine ganze Zahl von 1 bis 4, |
| b | 0 oder 1, |
| m und k | ganze Zahlen von 1 bis 12 und |
| n | je nach Wertigkeit von Q 1, 2 oder 3 |

bedeutet, wobei alle Reste gleicher Definition untereinander gleich oder verschieden sein können und wobei in mindestens einen Substituenten an der Gruppe Q a = O ist.

**2.** Gemisch nach Anspruch 1, dadurch gekennzeichnet, daß die Verbindung der Formel I mindestens zwei Acryl- oder Alkacrylsäureestergruppen enthält.

**3.** Gemisch nach Anspruch 1, dadurch gekennzeichnet, daß die Verbindung der Formel I mindestens eine Urethangruppe enthält.

**4.** Gemisch nach Anspruch 1, dadurch gekennzeichnet, daß R = $CH_3$ ist.

**5.** Gemisch nach Anspruch 1, dadurch gekennzeichnet, daß a = 0 oder 1 ist.

**6.** Gemisch nach Anspruch 1, dadurch gekennzeichnet, daß m eine Zahl von 2 bis 10 ist.

**7.** Gemisch nach Anspruch 1, dadurch gekennzeichnet, daß der photoreduzierbare Farbstoff ein Xanthen-, Benzoxanthen-, Benzothioxanthen-, Thiazin-, Pyronin-, Porphyrin- oder Acridinfarbstoff ist.

**8.** Gemisch nach Anspruch 1, dadurch gekennzeichnet, daß die durch Strahlung spaltbare Trihalogenmethylverbindung ein s-Triazin, das durch mindestens eine Trihalogenmethylgruppe und eine weitere Gruppe substituiert ist, oder ein Aryltrihalogenmethylsulfon ist.

**9.** Gemisch nach Anspruch 1, dadurch gekennzeichnet, daß das Bindemittel wasserunlöslich und in wäßrigalkalischen Lösungen löslich ist.

**10.** Gemisch nach Anspruch 1, dadurch gekennzeichnet, daß es 10 bis 80 Gew.-% Acryl- oder Alkacrylsäureester, 20 bis 90 Gew.-% polymeres Bindemittel und 0,05 bis 20 Gew.-%, bezogen auf die nichtflüchtigen Bestandteile des Gemischs, an strahlungsaktivierbaren Polymerisationsinitiatoren (c), (d) und (e) enthält.

**11.** Photopolymerisierbares Gemisch nach Anspruch 1, dadurch gekennzeichnet, daß es zusätzlich eine Dibenzalaceton- oder Cumarinverbindung (f) enthält.

**12.** Photopolymerisierbares Aufzeichnungsmaterial mit einem Schichtträger und einer photopolymerisierbaren Schicht, dadurch gekennzeichnet, daß die photopolymerisierbare Schicht aus einem Gemisch gemäß Anspruch 1 besteht.

## Claims

**1.** Photopolymerizable mixture which contains, as essential constituents,

a) a polymeric binder,
b) an acrylate or alkacrylate of a polyhydric alcohol,
c) a photoreducible dye,
d) a trihalomethyl compound which can be cleaved by irradiation, and
e) an acridine, phenazine or quinoxaline compound which acts as photoinitiator,

characterized in that the acrylate or alkacrylate is a compound of the formula I

$$Q[(-X^1-CH_2O)_a-CONH(-X^2-NHCOO)_b-X^3-OOC-\overset{R}{C}=CH_2]_n \qquad (I)$$

in which

Q denotes

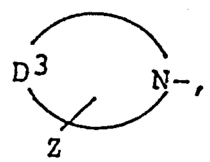

R denotes a hydrogen atom, a methyl group or an ethyl group,

$X^1$ denotes $C_mH_{2m}$ or

$$C_mH_{2m-1}O-CONH(-X^2-NHCOO)_b-X^3-OOC-\overset{R}{C}=CH_2,$$

$X^2$ denotes a saturated hydrocarbon group having 2 to 12 carbon atoms,

$X^3$ denotes a saturated hydrocarbon group which may be interrupted by 1 to 5 ether oxygen atoms,

$D^3$ denotes a saturated hydrocarbon group having 4 to 8 carbon atoms, which together with the nitrogen atom forms a 5- or 6-membered ring,

Z denotes a hydrogen atom or a group of the formula

$$C_kH_{2k}-O-CONH(-X^2-NHCOO)_b-X^3-OO\overset{R}{C}=CH_2,$$

a denotes zero or an integer from 1 to 4,

b denotes zero or 1,

m and k denote integers from 1 to 12, and

n denotes 1, 2 or 3, depending on the valency of Q,

it being possible for all radicals of the same definition to be identical to or different from one another, and 'a' being zero in at least one substituent of the group Q.

**2.** Mixture as claimed in claim 1, wherein at least two acrylate or alkacrylate groups are contained in the compound of the formula I.

**3.** Mixture as claimed in claim 1, wherein at least one urethane group is contained in the compound of the formula I.

**4.** Mixture as claimed in claim 1, wherein R denotes $CH_3$.

**5.** Mixture as claimed in claim 1, wherein "a" denotes zero or 1.

6. Mixture as claimed in claim 1, wherein "m" denotes an integer from 2 to 10.

7. Mixture as claimed in claim 1, wherein the photoreducible dye is a xanthene, benzoxanthene, benzothioxanthene, thiazine, pyronine, porphyrine or acridine dye.

8. Mixture as claimed in claim 1, wherein the trihalomethyl compound which can be cleaved by irradiation is an s-triazine which is substituted by at least one trihalomethyl group and one further group or is an aryl trihalomethyl sulfone.

9. Mixture as claimed in claim 1, wherein the binder is insoluble in water and soluble in aqueous-alkaline solutions.

10. Mixture as claimed in claim 1, characterized in that it contains 10 to 80 % by weight of acrylate or alkacrylate, 20 to 90 % by weight of polymeric binder and 0.05 to 20 % by weight of radiation-activatable polymerization initiators (c), (d) and (e), each time relative to the nonvolatile components of the mixture.

11. Photopolymerizable mixture as claimed in claim 1, characterized in that it additionally contains a dibenzal acetone or coumarine compound (f).

12. Photopolymerizable recording material comprised of a layer support and a photopolymerizable layer, characterized in that the photopolymerizable layer comprises a mixture as claimed in claim 1.

**Revendications**

1. Composition photopolymérisable comprenant les constituants essentiels suivants:
   a) un liant polymère,
   b) un ester d'aide acrylique ou alkylacrylique d'un polyol,
   c) un colorant photoréductible,
   d) un composé trihalogénométhylé clivable par irradiation, et
   e) un dérivé d'acridine, de phénazine ou de quinoxaline, actif comme amorceur photochimique,
   composition caractérisée en ce que l'ester d'acide acrylique ou alkylacrylique correspond à la formule I

   $Q[(-X^1-CH_2O)_a-CONH(-X^2-NHCOO)_b-X^3-OOC-C(-R)=CH_2]n$ (I),

   dans laquelle
   - Q est

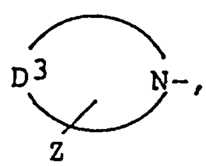

   - R représente l'atome d'hydrogène ou un groupe méthyle ou éthyle,
   - $X^1$ représente $C_mH_{2m}$ ou

     $C_mH_{2m-1}-O-CONH(-X^2-NHCOO)_b-X^3-OOC-C(-R)=CH_2$,

   - $X^2$ représente un groupe hydrocarboné en $C_{2-12}$ saturé,
   - $X^3$ représente un groupe hydrocarboné saturé, qui peut être interrompu par 1 à 5 atomes d'oxygène d'éther,
   - $D^3$ représente un groupe hydrocarboné en $C_{4-8}$ saturé, qui forme avec l'atome d'azote un cycle à 5 ou 6 chaînons,
   - Z représente l'atome d'hydrogène ou un radical de formule:

$C_kH_{2k}$-O-CONH(-$X^2$-NHCOO)$_b$-$X^3$-OOC-C(-R) = $CH_2$,

où

a vaut 0 ou un nombre entier de 1 à 4,
b vaut 0 ou 1,
m et k sont des nombres entiers de 1 à 12, et
n vaut, selon la valence de Q, 1, 2 ou 3,

tous les radicaux de même définition pouvant être identiques ou différents les uns des autres, et a = 0 dans au moins un substituant du groupe Q.

**2.** Composition selon la revendication 1, caractérisée en ce que le composé de formule I comporte au moins deux groupes ester d'acide acrylique ou alkylacrylique.

**3.** Composition selon la revendication 1, caractérisée en ce que le composé de formule I comporte au moins un groupe uréthane.

**4.** Composition selon la revendication 1, caractérisée en ce que R = $CH_3$.

**5.** Composition selon la revendication 1, caractérisée en ce que a = 0 ou 1.

**6.** Composition selon la revendication 1, caractérisée en ce que m est un nombre de 2 à 10.

**7.** Composition selon la revendication 1, caractérisée en ce que le colorant photoréductible est un colorant xanthène, benzoxanthène, benzothioxanthène, thiazine, pyronine, porphyrine ou acridine.

**8.** Composition selon la revendication 1, caractérisée en ce que le composé trihalogénométhylé clivable par irradiation est une s-triazine, qui est substituée par au moins un groupe trihalogénométhyle et un autre groupe, ou bien une aryltrihalogénométhylsulfone.

**9.** Composition selon la revendication 1, caractérisée en ce que le liant est insoluble dans l'eau et soluble dans les solutions alcalines aqueuses.

**10.** Composition selon la revendication 1, caractérisée en ce qu'elle contient 10 à 80 % en poids d'ester d'acide acrylique ou alkylacrylique, 20 à 90 % en poids de liant polymère et 0,05 à 20 % en poids, par rapport aux constituants non volatils du mélange, d'amorceurs de polymérisation (c), (d) et (e) activables par irradiation.

**11.** Composition photopolymérisable selon la revendication 1, caractérisée en ce qu'elle contient en outre un dérivé (f)de dibenzylidèneacétone ou de coumarine.

**12.** Matériau d'enregistrement photopolymérisable comprenant un substrat et une couche photopolymérisable, caractérisé en ce que la couche photopolymérisable est constituée d'une composition selon la revendication 1.